# EUROPÄISCHE PATENTSCHRIFT

(11) **EP 0 446 835 B1**
(45) Veröffentlichungstag und Bekanntmachung des Hinweises auf die Patenterteilung: **21.06.1995**
(21) Anmeldenummer: 91103689.5
(22) Anmeldetag: 11.03.1991
(51) Int. Cl.: C25D 5/54

(54) **Galvanisierungsverfahren**
Galvanizing process
Procédé de galvanisation

(30) Priorität: 16.03.1990 DE 4008482
(43) Veröffentlichungstag der Anmeldung: 18.09.1991
(73) Patentinhaber: Heraeus Noblelight GmbH, D-63801 Kleinostheim (DE)
(72) Erfinder: Esrom, Hilmar, Dr., W-6803 Edingen-Neckarhausen (DE); Elsässer, Gundolf, W-6904 Eppelheim (DE); Baier, Michael, W-6800 Mannheim (DE)
(74) Vertreter: Kühn, Hans-Christian

(56) Entgegenhaltungen:
- DE-A- 3 304 004
- FR-A- 2 425 790
- CHEMICAL ABSTRACTS, Band 109, Nr. 8, 22. August 1988, Zusammenfassung Nr. 62014k, Columbus, Ohio, US; H.S. COLE et al.: "Laser-activated copper desposition on polyimide"

## Beschreibung

Die Erfindung bezieht sich auf ein verfahren zum Galvanisieren von Substraten gemäß dem Oberbegriff des Patentanspruches 1.
Solche Verfahren finden dort Anwendung, wo die Oberflächen von Substraten teilweise oder vollständig mit einer metallischen Verstärkung versehen werden.

Bei den bis jetzt bekannten Galvanisierungsverfahren werden zur Metallisierung von Substraten aus Metallen, Kunststoffen oder anderen Werkstoffen die Oberflächen der Substrate zunächst in Vorbehandlungsbädern präpariert. Es schließen sich 7 bis 10 Bäder zur Aktivierung der Substratoberflächen an, die zur Vorbereitung für die nachfolgenden stromlosen chemischen Metallisierungsbäder erforderlich sind. Mit Hilfe von stromlosen chemischen Metallisierungsverfahren können auf die Substratoberflächen Kupfer, Nickel, Gold, Zinn, Palladium oder andere Metalle aufgetragen werden. Nach dem stromlosen Metallisieren der Oberfläche erfolgt die galvanische Verstärkung dieser Schichten mittels Kupfer, Nickel oder einem anderen Metall. Um bestimmte Strukturen auf der Oberfläche des Substrats zu erhalten, werden nicht erforderliche Bereiche im Anschluß an die Galvanisierung wieder abgeäzt.

Aus DE-A-3304004 ist es bekannt, Leiterplatten mit einer Aktivatorschicht aus Palladiumchlorid/Zinn(II)chlorid zu beschichten und anschließend ohne stromlose Metallisierung elektrolytisch zu verkupfern.

Chem. Abstr. Band 109, Nr. 8 (1988), Zusammenfassung Nr. 62014K, Columbus, Ohio, USA; H.S. Cole et al.:"Laser-activated Copper Deposition on Polyimide" beschreibt die Aufbringung von palladiumorganischen Verbindungen auf Polyimid mit anschließender Bestrahlung bei 351 nm. Die so erzeugte Palladiumkeimschicht wird stromlos verkupfert.

Der Erfindung liegt die Aufgabe zugrunde, ein Verfahren aufzuzeigen, mit dem Substrate aus einem organischen oder anorganischen Werkstoff einfacher, kostengünstiger sowie umweltfreundlicher als bisher galvanisch mit einer metallischen Verstärkung versehen werden können.

Diese Aufgabe wird erfindungsgemäß durch die Merkmale des Patentanspruches 1 gelöst.

Bei der Anwendung des erfindungsgemäßen Verfahrens kann auf Vorbehandlungsbäder zur Präperation der Substratoberflächen, auf Bäder zur Aktivierung der Oberfläche für eine stromlose chemische Metallisierung in Bädern sowie die stromlose chemische Metallisierung verzichtet werden. Erfindungsgemäß wird im ersten Schritt auf der Oberfläche eines Substrats ein Überzug in Form eines Aktivators partiell oder ganzflächig ausgebildet. Im zweiten Schritt kann die Oberfläche dieses Aktivators teilweise oder vollständig mit einem Metall verstärkt werden. Die Aktivatorschicht wird mit einer Dicke von kleiner/gleich 0,2 »m ausgebildet. Dies geschieht durch Auftragen einer Lösung, die wenigstens eine metallorganische Verbindung enthält, oder eines Pulvers aus dieser Verbindung. Durch Bestrahlen dieser Lösung bzw. dieses Pulvers mit einer Lichtquelle definierter Wellenlänge wird die metallorganische Verbindung in eine metallische Schicht umgesetzt. Anschließend kann diese Aktivatorschicht ganz oder teilweise elektrolytisch mit einer metallischen Verstärkung definierter Dicke versehen werden. Die partielle Ausbildung der Aktivatorschicht ist durch Anordnung einer Maske zwischen der Lichtquelle und der beschichteten Substratoberfläche möglich. Nicht bestrahlte Bereiche der aufgetragenen Lösung bzw. des Pulvers können nach Beendigung der Bestrahlung entfernt werden. Die so ausgebildete Aktivatorschicht kann unmittelbar nach Fertigstellung elektrolytisch verstärkt werden. Hierzu wird die zu verstärkende Aktivatorschicht an den Massepol einer Gleichspannungsquelle angeschlossen und in einem Metallbad angeordnet. Die elektrolytische Verstärkung der Aktivatorschicht erfolgt bei einer Temperatur von 25 bis 35°C und einer Gleichspannung von ca. 0,8 Volt. Sind die Aktivatorschichten als Leiterbahnen ausgebildet, so werden diese vor der elektrolytischen Verstärkung an den Massepol der Gleichspannungsquelle angeschlossen. Durch die Anwendung des erfindungsgemäßen Verfahrens wird die Galvanisierung der Substratoberfläche beschleunigt. Gleichzeitig werden durch Reduzierung einer Vielzahl von chemischen Prozessen die bei den herkömmlichen Verfahren auftretenden Umweltbelastungen reduziert.

Das erfindungsgemäße Verfahren wird nachfolgend anhand von schematischen Zeichnungen näher erläutert. Es zeigen:
- Fig. 1: die Behandlung einer Substratoberfläche gemäß dem erfindungsgemäßen Verfahren,
- Fig. 2: ein bestrahltes Substrat,
- Fig. 3: ein partiell elektrolytisch verstärktes Substrat,
- Fig. 4: ein Substrat, desen Oberfläche vollständig metallisch verstärkt ist.

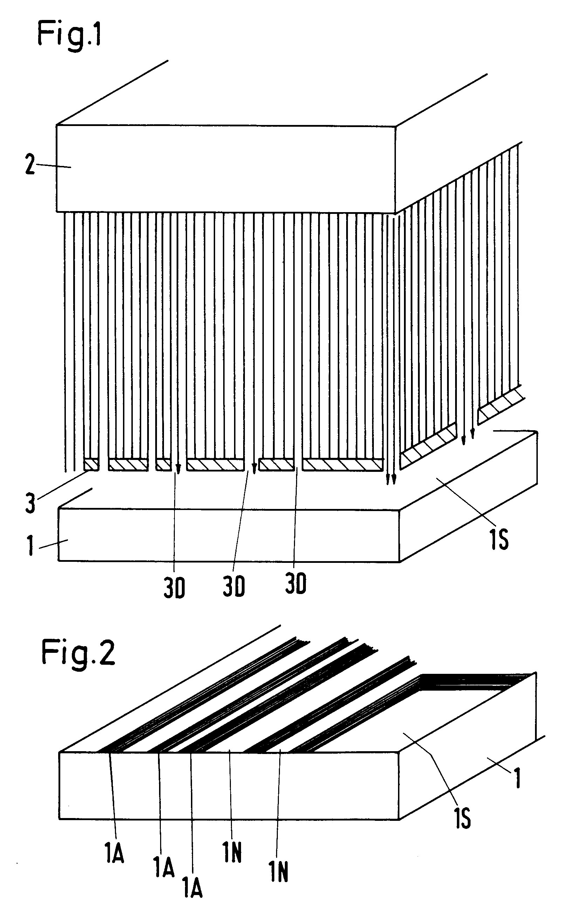

Fig. 1 zeigt ein flächiges Substrat 1, das bei dem hier dargestellten Ausführungsbeispiel aus einem keramischen Werkstoff in Form von Aluminiumoxid gefertigt ist. Es kann selbstverständlich auch ein Substrat verwendet werden, das aus einem Halbleitermaterial, einem Kunststoff, einem Metall oder aus einem supraleitenden keramischen oder metallischen Werkstoff gefertigt ist. Zur Ausbildung einer partiellen oder vollständigen Aktivatorschicht auf der Oberfläche des Substrats wird zunächst eine Lösung auf die Oberfläche 1S des Substrates 1, das in Fig. 1 dargestellt ist, aufgetragen. Die Lösung ist so ausgebildet, daß sie wenigstens eine metallorganische Verbindung aufweist. Die Metallkomponente dieser Verbindung wird so gewählt, daß sie das Metall enthält, das die Aktivatorschicht bilden soll. Bei dem hier dargestellten Ausführungsbeispiel ist auf die Oberfläche 1S eine Palladiumacetatlösung durch Tauchen oder Sprühen aufgebracht. In definiertem Abstand von der Oberfläche 1A ist ein UV-Hochleistungsstrahler 2 in Form eines Excimerlasers oder eines Excimerstrahlers angeordnet. Eine detaillierte Beschreibung eines solchen Hochleistungsstrahlers 2 kann der EP-OS 0 254 110 entnommen werden. Der Hochleistungsstrahler 2, der nachfolgend kurz als Excimerstrahler bezeichnet wird, besteht aus einem durch einseitig gekühlte Metallelektroden (hier nicht dargestellt), und einem Dielektrikum (hier ebenfalls nicht dargestellt) begrenzten und mit einem Edelgas oder Gasgemisch gefüllten Entladungsraum (hier nicht dargestellt). Das Dielektrikum und die auf der dem Entladungsraum abgewandten Oberfläche des Dielektrikums liegende zweite Elektrode sind für die durch stille elektrische Entladung erzeugte Strahlung transparent. Durch diese Konstruktion und durch eine geeignete Wahl der Gasfüllung wird ein großflächiger UV-Strahler mit hohem Wirkungsgrad geschaffen. Dieser arbeitet mit quasi gepulstem Betrieb. Bei dem hier dargestellten Ausführungsbeispiel weist der UV-Strahler eine Xenongasfüllung auf, mit der UV-Strahlung mit einer Wellenlänge zwischen 160 und 190 nm erzeugt werden kann. Die oben beschriebene Palladiumacetatlösung kann bei einer Wellenlänge von 172 nm zersetzt werden, so daß Xenon für diesen Fall die geeignete Gasfüllung ist. Mit einer Gasfüllung bestehend aus Kryptonfluorid wird UV-Strahlung im Bereich zwischen 240 bis 270 nm mit dieser Strahlungsquelle erzeugt. UV-Strahlung mit einer Wellenlänge zwischen 60 und 165 nm wird mit einer Helium- bzw. Argongasfüllung bewirkt. Bei Verwendung einer Gasfüllung bestehend aus Argonfluorid beträgt die Wellenlänge 180 bis 200 nm, während mit einem Gasgemisch aus Xenon und Chlor eine UV-Wellenlänge von 300 bis 320 nm erreicht werden kann. Mit Gasgemischen in Form von Argon/Fluor, Krypton/Fluor, Xenon/Chlor und Xenon/Fluor lassen sich Wellenlängen von 193 nm, 243 nm, 308 nm und 351 nm erzeugen. Der oben beschriebene Excimerlaser hat eine Pulsrate von 100 bis 200 Hz. Seine Pulsenergie beträgt 100 bis 200 mJ. An Stelle dieses Strahlers kann auch eine Vorrichtung verwendet werden, wie sie in der nicht vorveröffentlichten DE-A-39 19 538.4 offenbart ist. Diese Vorrichtung weist eine UV-Strahlungsquelle auf, die durch mehrere Elektroden gebildet wird, welche zylinderförmig ausgebildet und in geringem Abstand voneinander angeordnet sind. Jeweils zwei benachbarte Elektroden sind an eine hohe Wechselspannung angeschlossen. In die Spalte zwischen den Elektroden wird ein Gas eingeleitet. Hierdurch kommt es zu einer stillen Entladung, bei der UV-Stahlung mit einer Wellenlänge zwischen 90 nm und 200 nm, je nach verwendetem Gas, erzeugt wird.
Auf der zu beschichtenden Substratoberfläche 1S soll keine geschlossene Aktivatorschicht ausgebildet werden. Vielmehr sollen mehrere einzelne Aktivatorbahnen entstehen. Deshalb wird zwischen dem UV-Hochleistungsstrahler und der Oberfläche 1S des Substrats 1 eine Maske 3 angeordnet. Diese weist Durchlässe 3D auf. Diese Durchlasse 3D sind dort angeordnet, wo auf der Substratoberfläche 1S Aktivatorschichten ausgebildet werden sollen. Durch das Bestrahlen der Oberfläche 1S mit einem der UV-Hochleistungsstrahler 2 wird die metallorganische Verbindung zersetzt, und es kommt zur Ausbildung von metallischen Schichten in den bestrahlten Bereichen. Die nicht bestrahlte Lösung kann nach Beendigung der Bestrahlung beseitigt werden. Wie an Hand von Fig. 2 zu sehen ist, sind nach Beendigung der Bestrahlung auf der Substratoberfläche 1S mehrere Aktivatorschichten 1A ausgebildet. Zwischen den Aktivatorschichten 1A sind nicht beschichtete Bereiche 1N zu sehen. Die Aktivatorschichten 1A können nun elektrolytisch mit einer Metallschicht verstärkt werden. Zu diesem Zweck werden die Schichten 1A an den Massepol einer Gleichspannungsquelle angeschlossen und bei einer Temperatur von 25°C bis 35°C in einem Metallbad angeordnet. Der zweite Pol der Gleichspannungsquelle wird an die zweite Elektrode angeschlossen. Zur Verbesserung der elektrischen Verbindung zwischen den Aktivatorschichten 1A und dem Massepol kann zwischen beiden ein Nickelplättchen angeordnet werden. Mit Hilfe einer Gleichspannung, die ca. 0,8 Volt beträgt, und einem Gleichstrom von I = 24 mA kann auf der Oberfläche der Aktivatorschichten 1A eine Metallschicht abgeschieden werden. Die Temperatur der Elektrolytlösung beträgt 25 bis 35°C. Nach Beendigung des Galvanisierungsvorgangs sind auf der Oberfläche 1A die Metallisierungsschichten 2M mit einer Dicke von 5 mm und mehr ausgebildet.

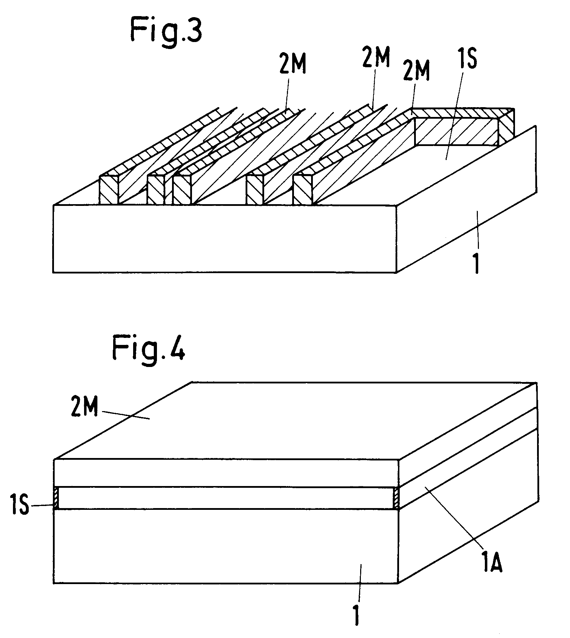

Es ist auch möglich, die Substratoberfläche 1S vollständig mit einer Aktivierungsschicht 1A zu überziehen. Dies wird durch Weglassen der Maske 3 bewirkt. Fig. 4 zeigt eine Substratoberfläche, die vollständig mit einer Metallschicht 2M verstärkt ist. Hierfür wird zunächt die gesamte Oberfläche 1S des Substrats 1 mit einer Aktivatorschicht 1A überzogen, und dann eine elektrolytische Abscheidung auf dieser Aktivatorschicht 1S durchgeführt. Erfindungsgemäß können mit der elektrolytischen Abscheidung Metallisierungen der Aktivatorschicht mit Nickel, Kupfer, Kupferlegierungen, Chrom, Zink, Zinn Cadmium, Zinnlegierungen, Silber, Gold, Palladium, Rhodium und Indium erzeugt werden. Die elektrolytische Abscheidung von Eisen, Aluminum, Cadmium und Zink als chemische Schutzschichten ist ebenfalls möglich.

## Patentansprüche

1. Verfahren zum Galvanisieren von Substraten (1) aus einem organischen oder anorganischem Werkstoff, wobei auf der Oberfläche (1A) des Substrats (1) eine geschlossene bzw. eine oder mehrere partiell ausgebildete Aktivatorschichten (1A) gebildet werden, die im unmittelbaren Anschluß daran elektrolytisch mit einer Metallschicht verstärkt werden, wobei zur Herstellung der Aktivatorschichten (1A) ein Lösungsfilm, der eine metallorganische Verbindung enthält, oder ein Pulver aus dieser Verbindung, auf die Oberfläche (1S) des Substrats (1) aufgetragen wird, dadurch gekennzeichnet, daß die Lösung bzw. das Pulver vollständig oder partiell mit einem Hochleistungsstrahler (2) bestrahlt wird, der UV-Strahlung mit einer Wellenlänge zwischen 60 nm und 320 nm erzeugt.

2. Verfahren nach Anspruch 1, dadurch gekennzeichnet, daß zur Herstellung von ganzflächigen oder partiellen metallischen Aktivatorschichten (1A) eine Lösung, die Palladiumacetat, Palladiumchlorid, Cyclopentadienylpalladiumallyl oder Cyclopentadienylpalladiumchlorid enthält, oder ein Pulver aus einer dieser Verbindungen auf die Oberfläche (1A) des Substrats (1) aufgetragen wird.

3. Verfahren nach Anspruch 1 oder 2, dadurch gekennzeichnet, daß zur galvanischen Verstärkung der Aktivatorschichten (1A) diese bei einer Temperatur von 25°C bis 35°C an den Massepol einer Gleichspannungsquelle angeschlossen und in einem Metallbad angeordnet werden, in dem eine zweite an den zweiten Pol der Gleichspannungsquelle angeschlossene Elektrode angeordnet ist.

4. Verfahren nach Anspruch 3, dadurch gekennzeichnet, daß die Aktivatorschichten (1A) in einem Bad aus Kupfer, einer Kupferlegierung, Chrom, Zink, Zinn, einer Zinnlegierung, Cadmium, Silber, Gold, Palladium, Rhodium oder Indium angeordnet werden.

## Claims

1. A method for galvanizing substrates (1) of an organic or inorganic material, in which there are formed on the surface (1A) of the substrate (1) one closed or one or more partially constructed activator layers (1A), which immediately adjoining thereto are reinforced electrolytically with a metal layer, in which for the production of the activator layers (1A) a solution film, which contains an organometallic compound, or a powder of this compound, is applied onto the surface (1S) of the substrate (1), characterised in that the solution or the powder is irradiated completely or partially by a high-power radiating device (2), which produces UV-radiation with a wave length of between 60 nm and 320 nm.

2. A method according to Claim 1, characterised in that for the production of metallic activator layers (1A), over the whole area or partial, a solution which contains palladium acetate, palladium chloride, cyclopentadienylpalladium ally or cyclopentadienylpalladium chloride, or a powder of one of these compounds is applied onto the surface (1A) of the substrate (1).

3. A method according to Claim 1 or 2, characterised in that for the galvanic reinforcement of the activator layers (1A), the latter are connected to the earth pole of a direct current source at a temperature of 25° C to 35° C and are arranged in a metal bath, in which a second electrode is arranged which is connected to the second pole of the direct current source.

4. A method according to Claim 3, characterised in that the activator layers (1A) are arranged in a bath of copper, a copper alloy, chromium, zinc, tin, a tin alloy, cadmium, silver, gold, palladium, rhodium or indium.

## Revendications

1. Procédé pour la galvanisation de substrats (1) constitués d'une matière première organique ou inorganique, étant entendu que sur la surface (1A) du substrat (1) sont formées une ou plusieurs couches d'activateur partiellement formées ou une couche d'activateur fermée (1A), qui dans un branchement direct y sont ensuite électrolytiquement renforcées avec une couche métallique, un film de solution qui contient un composé organo-métallique ou une poudre de ce composé étant appliqué sur la surface (1S) du substrat (1) pour la préparation des couches d'activateur (1A), caractérisé en ce que la solution ou la poudre est irradiée complètement ou partiellement avec une source de rayonnement à haut rendement (2) qui produit un rayonnement UV avec une longueur d'onde comprise entre 60 nm et 320 nm.

2. Procédé selon la revendication 1, caractérisé en ce qu'on applique pour la préparation de couches d'activateur métalliques complètes ou partielles (1A) une solution qui contient de l'acétate de palladium, du chlorure de palladium, du cyclopentadiénylallylpalladium ou du chlorure de cyclopentadiénylpalladium, ou une poudre constituée d'un de ces composés sur la surface (1A) du substrat (1).

3. Procédé selon la revendication 1 ou 2, caractérisé en ce que pour le renforcement galvanique des couches d'activateur (1A) celles-ci sont raccordées à une température de 25°C à 35°C au pôle de la masse d'une source de tension continue et disposées dans un bain de métal, dans lequel est disposée une deuxième électrode raccordée au deuxième pole de la source de tension continue.

4. Procédé selon la revendication 3, caractérisé en ce que les couches d'activateur (1A) sont disposées dans un bain constitué de cuivre, d'un alliage de cuivre, de chrome, de zinc, d'étain, d'un alliage d'étain, de cadmium, d'argent, d'or, de palladium, de rhodium, ou d'indium.
